# EUROPEAN PATENT SPECIFICATION

(11) **EP 0 838 896 B1**
(45) Date of publication and mention of the grant of the patent: **02.06.2004**
(21) Application number: 97308399.1
(22) Date of filing: 22.10.1997
(51) Int. Cl.: H03G 3/30, H04B 1/10

(54) **Radio receiver gain control**
Verstärkungsregelung eines Funkempfänger
Réglage de gain pour un récepteur radio

(30) Priority: 23.10.1996 JP 28074296
(43) Date of publication of application: 29.04.1998
(73) Proprietor: NEC CORPORATION, Tokyo (JP)
(72) Inventor: Takaki, Tetsuya, Minato-ku, Tokyo (JP)
(74) Representative: W.P. THOMPSON & CO.

(56) References cited:
- US-A- 4 667 334
- PATENT ABSTRACTS OF JAPAN vol. 1996, no. 05, 31 May 1996 (1996-05-31) & JP 08 018469 A (HITACHI LTD), 19 January 1996 (1996-01-19)
- PATENT ABSTRACTS OF JAPAN vol. 017, no. 504 (E-1430), 10 September 1993 (1993-09-10) & JP 05 129862 A (NEC ENG LTD), 25 May 1993 (1993-05-25)

## Description

The present invention relates to a radio receiver. In a particular radio receiver to be described below, by way of example in illustration of the invention, intermodulation, caused by a plurality of interfering waves and synthesized by a non-linearity in a receiver, is effectively suppressed, when two or more intense interfering waves, with the exception of a signal which is being received by the receiver, exist at the same time.

In a receiver used in a radio communication equipment for example a cellular phone, or a selective call radio receiver (a so-called pager), except when a desired signal wave is being received by the receiver, the existence of two or more intense interfering wave signals at the same time is liable to result in interfering signals being synthesized, due for example to a non-linearity in a high-frequency amplifier, which acts as a frequency mixer, and for a signal at or near the frequency of the desired signal to be produced. This problem, which is usually known as cross modulation, or intermodulation, (hereinafter abbreviated as IM), is one of the important factors influencing the performance of the receiver. Upon the generation of an IM signal, even when the receiver receives the desired signal wave at a sufficiently large strength relative to thermal noise, there is a deterioration in the receiving quality of the receiver. This is liable to result in a deterioration in the level of the error ratio in a digital communication system, or in a deterioration in the SINAD ratio (Signal+Noise+Distortion to Noise-Distortion ratio) in an analog communication system.

Methods of preventing the deterioration of the receiving quality of a receiver caused by the generation of an IM signal have previously been proposed in the published specification of Japanese patent application No. Hei 5-335857 (hereinafter, referred to as the first prior proposal) and in the published specification of Japanese patent application No. Hei 7-212262 (hereinafter, referred to as the second prior proposal).

Further methods or circuits are known e.g from US-A-4 667 334 and JP-A-5-08-118469. However, none of these prior art documents discloses a gain control means in the intermediate frequency path preceding the demodulator which is controlled by the demodulator.

Reference will now be made to Figs. 1 to 4 of the accompanying drawings in which:-
Fig. 1 is a block schematic diagram illustrating the radio receiver disclosed in the first prior proposal,
Fig. 2 is a block schematic diagram illustrating the radio receiver disclosed in the second prior proposal,
Fig. 3 is a block schematic diagram illustrating a resonance circuit employed in the receiver shown in Fig. 2, and
Fig. 4 illustrates the frequency response of the resonance circuit shown in Fig. 3.
Fig. 5 is a block schematic diagram illustrating a radio receiver according to the invention.

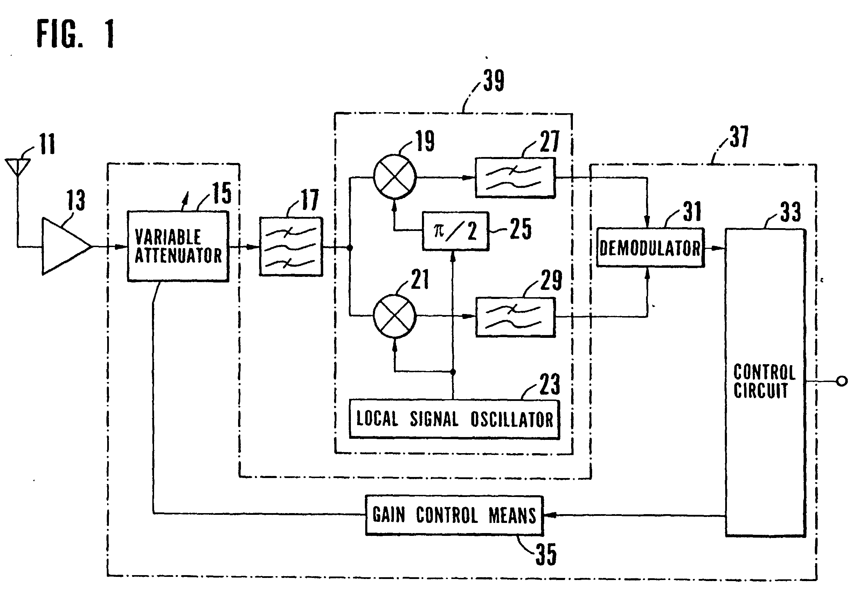

In Fig. 1, a signal received by an antenna 11 is amplified in a high-frequency amplifier 13, and passed to a variable attenuator 15, whose output is applied to a high-frequency (band pass) filter 17. The output of the high-frequency filter 17 is divided into two, and passed to frequency mixers (converters) 19 and 21, and converted to base band signals employing a local oscillating signal obtained from a local oscillator 23, which is fed to mixer 19 via a phase shifter (π/2) 25 in order to provide a π/2 phase shift. Thereafter, the base band signals from the outputs of the frequency mixers 19 and 21 are passed to respective base band filters 27 and 29, and are demodulated to provide digital signals at the output of a demodulator 31 and passed to a control circuit 33. A frame synchronous signal is detected in the control circuit 33. If the frame synchronous signal is not detected within a predetermined time in the control circuit 33, a step-out signal is transmitted from the control circuit 33 to a gain control means 35, and the gain control means 35 changes the attenuation value of the variable attenuator 15. By changing the attenuation value of the variable attenuator 15, the cross modulation influence caused by interfering waves is removed. When a frame synchronous signal is detected in the control circuit 33, the gain control means 35 operates so as to reset the attenuation value of the variable attenuator 15 to its original value. Here, for convenience of description, the frequency mixers 19, 21, the local oscillator 23, the phase shifter 25 and the base band filters 27 and 29 are called a base band signal conversion means. Also, the variable attenuator 15, the gain control means 35, the demodulator 31 and the control circuit 33 are called a control means 37.

According to a prior proposal, considering the attenuation value of the variable attenuator 15 beforehand, when the field strength of the received signal transmitted to the control circuit 33 is high, but no frame synchronous signal is detected, then it is determined that cross modulation is caused in a signal band of a desired wave signal by a plurality of interfering waves, other than the desired signal wave, and the attenuation value of the variable attenuator 15 is controlled. Therefore, a cross modulation signal generated after the variable attenuator 15 can be suppressed.

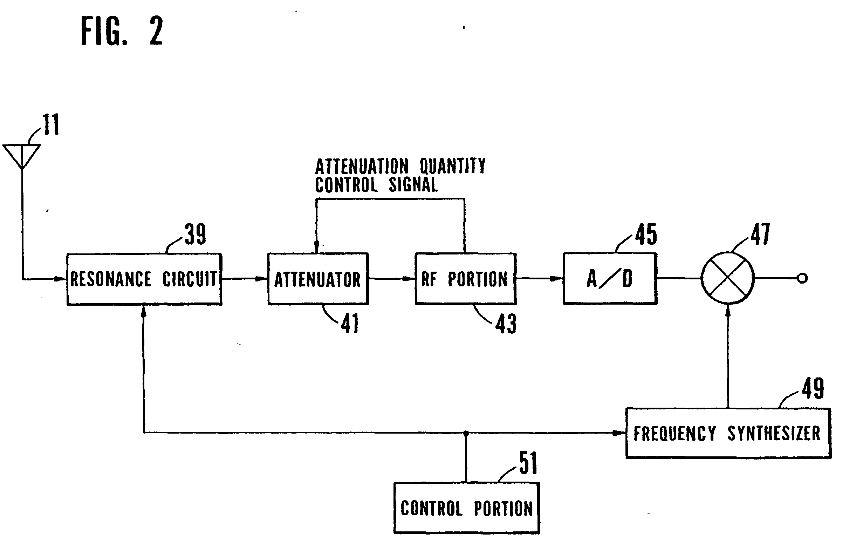

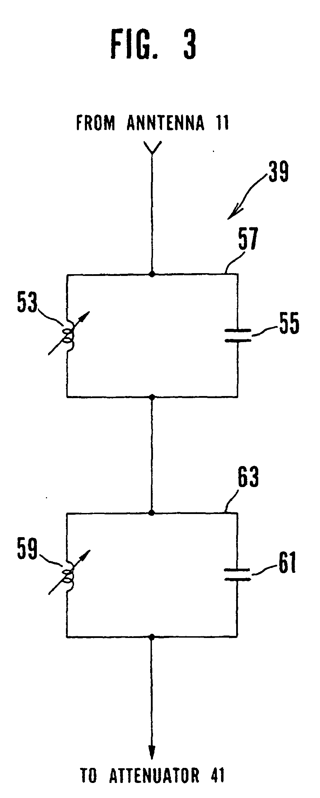

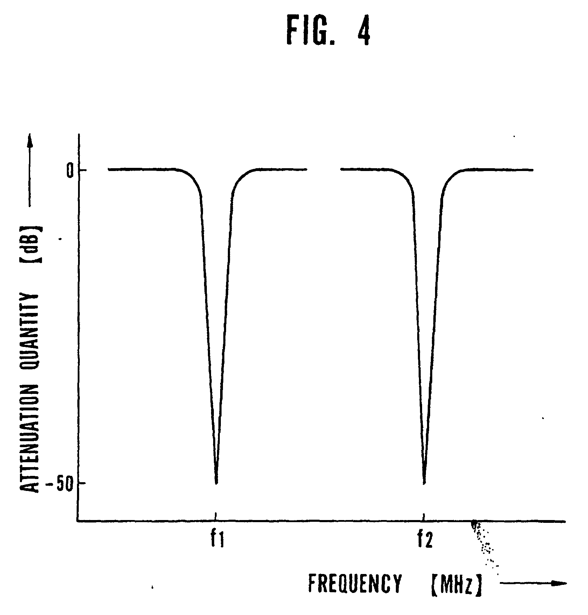

Figs. 2, 3 and 4 are views showing the constitution of a receiver disclosed in the second prior proposal. In Fig. 2, a signal received by the antenna 11 passes a resonance circuit 39, as described later referring to Fig. 3, and is transmitted via an attenuator 41 to an RF portion 43. The RF portion 43 generates a signal for controlling the attenuation value of the attenuator 41 in accordance with the intensity of a received signal, thereby controlling the attenuator 41, so that the field intensity of the received signal transmitted to the RF portion 43 is at a constant level. The received signal thus controlled to a constant level is amplified in the RF portion 43, converted from an analog signal to a digital signal by an analog-digital converter (A/D) 45, and subsequently transmitted to a digital mixer 47. The digital mixer 47 also receives a local oscillator signal generated by a frequency synthesizer 49. In the digital mixer 47, the digital signal transmitted from the A/D 45 is converted to an intermediate frequency in a process known as a heterodyne process. A control portion 51 is arranged so as to control not only a frequency emitted from the frequency synthesizer 49, but the resonance frequency of the resonance circuit 39 provided at the front end of the receiver. Fig. 3 is a view showing the constitution of the resonance circuit 39 of Fig. 2. In the resonance circuit 39, a parallel LC resonance circuit 57, including a variable inductor 53 and a fixed capacitor 55, and a parallel LC resonance circuit 63, having a variable inductor 59 and a fixed coil 61, are connected in series. The variable inductors 53 and 59 can have inductance values which are controlled by control signals from the control portion 51 (see Fig. 2), respectively. The resonance frequencies of the parallel LC resonance circuits 57 and 63 can be changed. The frequency characteristics of the parallel LC resonance circuits 57 and 63 operate as notch filters which cause an attenuation of 50dB or more at the respective resonance frequencies of the circuits, and are hardly attenuated at all in frequency bands other than at the resonance frequencies.

In the prior proposals, when, except for a desired signal frequency of the receiver, two or more interfering signal waves exist, and the field strength of the received signal is high, but the receiving sensitivity is lowered, then it is determined that the interfering waves are caused by cross modulation in a frequency band of the desired signal wave, and the interfering waves are removed by adapting the resonance frequencies of the parallel LC resonance circuits 57 and 63 to the frequencies of the interfering waves. Therefore, a deterioration in the receiver's sensitivity resulting from cross modulation can be prevented.

A first problem with the aforementioned first prior proposal is that the deterioration in the receiving sensitivity resulting from the cross modulation caused by a plurality of interfering waves, other than the desired received frequency, is determined by detecting whether or not the frame synchronous signal exists in a received frame. Therefore, it is not possible to determine whether or not the cross modulation is caused by a plurality of interfering waves.

For example, in North America, there is a system TIA IS95, which has a pilot channel transmitting a signal for obtaining synchronization with the system, a synchronous channel transmitting a signal for obtaining frame synchronization and a plurality of a traffic channels for transmitting voice or other information signals. Further, the transmission power ratio of each channel with respect to that of the base station is different, such that the ratios to the pilot channel: the synchronous channel: and the traffic channel are respectively 3:1:1. In this system, a plurality of intense interfering waves which cause cross modulation exist, and a cross modulation signal produced by the interfering waves falls in a band of a desired signal frequency. In this case, even if a receiver can obtain synchronization with the base station via the pilot channel, at the time of receipt of the traffic channel, the cross modulation signal caused by two or more interfering waves falls into the received band of the desired signal frequency, and deterioration in the receiving sensitivity is likely to occur. This is because the receiver takes the frame synchronous signal from a received frame, and the detection of the frame synchronous signal is used to determine that deterioration of the receiving sensitivity resulting from the cross modulation, caused by a plurality of interfering waves, occurs. For example, as in the aforementioned North American TIAòIS95 system, in which a synchronous signal is exchanged with the base station using a plurality of channels, the receiver determines, only by determining whether or not the frame synchronous signal is detected, that a deterioration of the receiving sensitivity, as a result of cross modulation caused by a plurality of interfering waves, occurs.

A second problem with the aforementioned first prior proposal is that using the variable attenuator 15 inserted at the front end of the receiver, not only the cross modulation signal produced by a plurality of interfering waves, but also the field intensity of the received signals, including the desired wave signal, are adjusted. Therefore, the input power level of the demodulation signal transmitted to the demodulator 31 is not constant, and the demodulator 31 requires a very large input dynamic range.

The reasons for this are explained below. When the cross modulation is caused by a plurality of interfering waves, in order to suppress the cross modulation in or after the variable attenuator 15, the attenuation value of the variable attenuator 15 is controlled to provide a high value of attenuation. However, at the same time the cross modulation caused by a plurality of interfering waves is suppressed, the received power level of the desired wave transmitted to the demodulator 31 is also suppressed, and the input power level of the demodulator 31 is decreased. Also, when there are no interfering waves causing cross modulation, the attenuation value of the variable attenuator 15 is controlled to provide a small value of attenuation. Therefore, the received power level transmitted to the demodulator 31 becomes high, as compared to the case in which there are interfering waves.

Furthermore, a first problem with the aforementioned second prior proposal is that when there are a plurality of combined interfering waves causing cross modulation, a plurality of notch filters, which can vary the resonance frequencies, as shown in Fig. 3, are required at the front end of the receiver. Also, even when a plurality of variable notch filters are incorporated, the resonance frequency of the resonance circuit has to be synchronized with each of the frequencies of the interfering waves causing cross modulation. Therefore, any method of controlling the resonance circuit becomes very complicated.

This is because the frequencies of the interfering waves causing the cross modulation usually have a three-dimensional distortion component produced by the non-linearity of the high-frequency amplifier in the receiver. When the frequency of the desired wave is set at fc and the frequency of the interfering waves causing cross modulation is an optional fl, then fc+fl and fc+2fl or fc-fl and fc-2fl can be obtained. An infinite number of combinations of the interfering wave frequencies exist. For this, it is difficult to provide a plurality of notch filters which can be synchronized to all of the interfering wave frequencies. Further, it is difficult to control and synchronize the resonance frequency of the resonance circuit to all of the interfering wave frequencies.

Features of a receiver to be described below, by way of example in illustration of the present invention are that it provides for the suppression of a n(n≥2)-dimensional distortion component produced by the non-linearity of a high-frequency amplifier, a frequency mixer or the like in the receiver, and that deterioration in the receiving sensitivity of the receiver resulting from cross modulation caused by the existence of a plurality of interfering waves can be reduced.

The n(n≥2)-dimensional distortion component produced by the non-linearity of the high frequency amplifier, the frequency mixer and the like in the receiver has been found, when the field intensity increases or decreased by α dB, to be increased or decreased by n α dB in proportion. A variable gain means whose gain value can be controlled is provided at the front end of a receiver to be described below in illustration of the invention. After the receiver receives a signal transmitted from a base station, the value of the gain of the variable gain means is controlled, and the gain value of the variable gain means is attenuated by α dB. When the level of the field of a signal being received by the receiver is, for example, β dB or less, it is determined that cross modulation by means of interfering waves would not occur, and the variable gain means is not controlled. However, when the value of the gain of the variable gain means is attenuated by α dB and the level of the field of the received signal being received by the receiver is attenuated by β dB (α<β) or more, it is determined that the cross modulation by a plurality of interfering waves occurs, and further the gain value of the variable gain means is controlled. The gain value of the variable gain means is increased, until a bit error ratio of the received signal reaches a value which is not influenced by the cross modulation. By this method, the aforementioned problems are minimised.

A receiver for achieving radio communication with a base station to be described below, by way of example in illustration of the invention, has receiving means for receiving a signal transmitted from the base station, a first filtering means having a bandwidth for passing only a desired signal wave from among a band of radio frequency signals, a frequency conversion extraction means for converting a received signal in a radio frequency band to a signal in an intermediate frequency band and for extracting the converted signal, and a control means for demodulating the received signal received by the receiver while the gain of the received signal is controlled. The control means has a demodulating means for demodulating the signal in the intermediate frequency band, and a first variable gain means arranged before the frequency conversion extraction means and having a gain which can be controlled. The frequency conversion extraction means has a second variable gain means whose gain is controlled by the demodulating means.

In a particular receiver to be described in illustration of the invention, the frequency conversion extraction means is preferably provided with a frequency conversion means for converting the received signal in the radio frequency band to the signal in the intermediate frequency band, a local signal oscillating means connected to an input of the frequency conversion means for generating a local oscillator signal used when the signal in the radio frequency band is converted to the signal in the intermediate frequency band, and a second filtering means provided between the first variable gain means and the demodulating means for passing only the received signal in the intermediate frequency band converted by the frequency conversion means and having a bandwidth which extends over as much as one channel. Also, in the receiver to be described, the control means is provided with an error ratio calculation means for calculating an error ratio of the received signal from a demodulation result of the demodulating means and a gain value control means for controlling the gain of the first variable gain means. From a control value transmitted from the demodulating means for controlling the gain of the second variable means and a control value transmitted from the gain value control means for controlling the gain of the first variable gain means, a power value of the received signal being received at that time is preferably obtained.

One particular receiver illustrative of the present invention has the first variable gain means between an antenna for receiving a signal transmitted from the base station and an antenna sharer for separating a band of the received signal and a band of a transmitted signal. Further, the receiver has a demodulator, a control circuit having a bit error ratio calculation means for calculating a bit error ratio of the received signal and the gain value control means for controlling the gain value of the first variable gain means, and the second variable gain means for keeping constant the level of the field of the received signal transmitted to the demodulator.

Also in the particular receiver, the gain value of the first variable gain means is set to a minimum gain value beforehand. Upon the receipt of a signal transmitted from the base station, the gain value of the second variable gain means is changed. The level of the field of the received signal (assumed to be adBm) is set up to an input level satisfied by the demodulator. In this case, a gain control signal transmitted from the demodulator to the second variable gain means is a voltage value proportional to a gain variation. By comparing the gain control signal before the gain control with the gain control signal after the gain control, the control means is able to calculate the gain variation of the second variable gain means. Subsequently, by attenuating the gain value of the first variable gain means by α dB and again controlling the gain value of the second variable gain means, the field level of the received signal transmitted to the demodulator is set to adBm. In this case, if the gain variation of the second variable gain means is β dB or more, it is determined that cross modulation by interfering waves would occur, and using the gain value control means, the gain value of the first variable gain means is further increased. Subsequently, the bit error ratio of the received signal is calculated using the bit error ratio calculation means. If relative to a received field level, the calculated bit error ratio is lower than a certain threshold level, it is determined that the influence of cross modulation caused by the interfering waves cannot be removed, and the gain value of the first variable gain means is further increased. By repeating this method, the deterioration of the receiving sensitivity caused by the cross modulation due to the interfering waves can be effectively minimised.

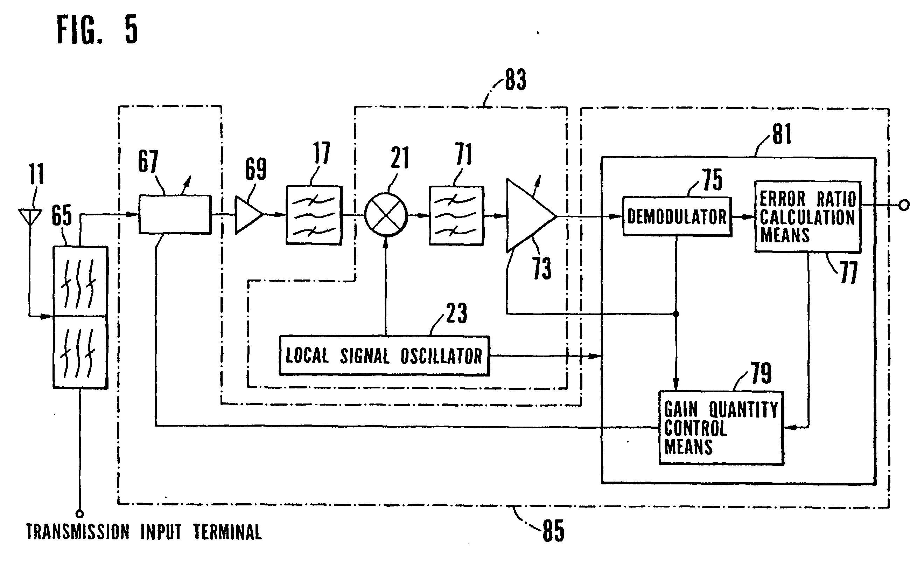

The following description, and Fig. 5 of the drawings, disclose, by means of an example, the invention which is characterised in the appended claims, whose terms determine the extent of the protection conferred hereby.

In Fig. 5 there is shown a block schematic diagram of a radio receiver.

Referring to Fig. 5, the receiver is of a super heterodyne system. The receiver is provided with an antenna 11 as a receiving means for receiving a signal transmitted from a base station (not shown); an antenna sharer 65 as a first band bass filtering means for passing only a received or transmitted radio signal and separating a received signal from a transmitted signal; a first variable gain means 67 inserted for preventing a deterioration of the receiving sensitivity caused by cross modulation; a high-frequency amplifier 69 as a frequency band amplifying means having a relatively large gain for decreasing the noise index of the entire receiver; a band pass filter 17 as a first filtering means or a second band pass filtering means having a bandwidth in accordance with the received signal used in a radio frequency band for passing only an object desired wave signal; a local signal oscillator 23 as a local signal oscillating means for oscillating a local oscillating signal used when the received signal in the radio frequency band to the received signal in an intermediate frequency band; a frequency converter 21 as a frequency conversion means for converting the received signal in the radio frequency band to the received signal in the intermediate frequency band using the local oscillating signal oscillated by the local signal oscillator 23; a band pass filter 71 as a second filtering means or a third filter band pass filtering means having a bandwidth as much as one channel for passing only the received signal converted to the signal in the intermediate frequency band; a second variable gain means 73 for keeping constant a power level of the received signal; a demodulator 75 as a demodulating means for converting the received signal in the intermediate frequency band to a signal in a base band and further converting an analog signal to a digital signal; an error ratio calculation means 77 for calculating a bit error ratio of the demodulated digital signal; and a gain value control means 79 for controlling the gain value of the first variable gain means 67.

The demodulator 75, the error ratio calculation means 77 and the gain value control means 79 constitute a control circuit 81 to control the operation of the entire receiver. Also, the control circuit 81 and the first variable gain means 67 constitute a control means 85. Also, the frequency converter 21, the band pass filter 71, the second variable gain means 73 and the local signal oscillator 23 constitute a frequency conversion extraction means 83.

The antenna 11 is connected to an input/output end common to transmission and receipt of the antenna sharer 65 as a third filtering means, and a receiving-side output end of the antenna sharer 65 is connected to an input of the first variable gain means 67. The first variable gain means 67 can control a gain value with a control signal transmitted from the gain value control means 79 in the control circuit 81. A transmission-side input end of the antenna sharer 65 is connected to an output of a transmission large gain amplifier (not shown). An output of the first variable gain means 67 is connected to an input of the high-frequency amplifier 69, and an output of the high-frequency amplifier 69 is connected to an input of the band pass filter 17. An output of the band pass filter 17 is connected to an input end of the frequency converter 21 for receiving the signal in the radio frequency band. Further, to another input end for the local oscillating signal of the frequency converter 21, an output of the local signal oscillator 23 is connected. An oscillating frequency of the local signal oscillator 23 can be optionally set by the control circuit 81. An output end of the frequency converter 21 for emitting the signal in the intermediate frequency band is connected to an input end of the band pass filter 71, and an output end of the band pass filter 71 is connected to an input end of the second variable gain means 73. The second variable gain means 73 can control a gain with a control signal transmitted from the demodulator 75 in the control circuit 81. An output end of the second variable gain means 73 is connected to an input of the demodulator 75 in the control circuit 81, and an demodulation output of the demodulator 75 is connected to the error ratio calculation means 77. The control signal emitted from the demodulator 75 for controlling the gain value of the second variable gain means 73 and the control signal from the error ratio calculation means 77 are connected to the gain value control means 79.

Operation of the embodiment illustrative of the invention is now detailed referring again to Fig. 5. First the receiver sets the gain value of the first variable gain means 67 to be a minimum gain value. The signal received by the antenna 11 passes the antenna sharer 65 and is transmitted to the first variable gain means 67. The signal having passed the first variable gain means 67 is transmitted to the high-frequency amplifier 69, amplified in the high-frequency amplifier 69 as much as the gain value the high-frequency amplifier 69 has, and transmitted to the band pass filter 17. Subsequently, the received signal having passed the band pass filter 17 is transmitted to the frequency converter 21. In the frequency converter 21, the input received signal in the radio frequency band and the local oscillating signal from the local signal oscillator 23 are mixed, converted to the signal in the intermediate frequency band, and emitted. The received signal converted to the signal in the intermediate frequency band by the frequency converter 21 passes the band pass filter 71, and is transmitted to the second variable gain means 73. The received signal emitted from the second variable gain means 73 is transmitted to the demodulator 75 in the control circuit 81. The demodulator 75 emits the control signal for controlling the gain value of the second variable gain means 73 in accordance with the power level of the received signal transmitted to the demodulator 75, and the gain value of the second variable gain means 73 is controlled, so that the power level of an output signal from the second variable gain means 73 becomes constant. In this case, the control signal emitted from the demodulator 75 for controlling the gain value of the second variable gain means 73 is a voltage value which increases or decreases in proportion to the gain value of the second variable gain means 73. In the control circuit 81, based on the voltage level of the control signal, the power level transmitted to the second variable gain means 73 at the present time can be known, and from an increase/decrease level of the entire gain, the received power level transmitted to the antenna 11 can be known. The demodulator 75 demodulates the received signal, concurrently converts the received signal to a base band signal, further converts an analog signal to a digital signal, and emits the signal. The signal emitted from the demodulator 75 is digital-processed in a base band applied at the base station in the error ratio calculation means 77, which calculates the bit error ratio of the received signal.

Usually, a cross modulation signal produced by two or more interfering waves is an n-dimensional distortion component caused by the non-linearity of the high-frequency amplifier 69 and the frequency converter 21 constituting the receiver. The distortion component has the property of increasing or decreasing by n α dB in proportion as the power of the cross modulation signal increases or decreases by α dB.

Using this property, the receiver being described receives a signal transmitted from the base station, then controls the gain value of the second variable gain means 73, keeps constant the power level of the received signal transmitted to the demodulator 75, and at the same time knows the power level of the received signal received at the end of the antenna 11 at the present time. Subsequently, the control circuit 81 controls the gain value of the first variable gain means 67 using the gain value control means 79, to attenuate the gain value of the first variable gain means 67 by α dB, and attenuates the input power level of the received signal transmitted to the demodulator 75 by **α** dB. Then, the demodulator 75 operates so as to keep constant the power level of the received signal transmitted thereto, and, therefore, emits a control signal for increasing the gain value of the second variable gain means 73. When the gain variation of the second variable gain means 73 is within β dB, for example, the gain value of the first variable gain means 67 is attenuated by 1dB. In this case, when the variation of the power level of the control signal emitted from the demodulator 75 for controlling the gain of the second variable gain means 73 corresponds to the variation for increasing the gain value of the second variable gain means 73 by 1dB, then the control circuit 81 determines that no cross modulation signal is produced by the interfering waves. The gain value of the first variable gain means 67 is controlled so as to return to the initial gain value, via the gain value control means 79 for controlling the gain value of the first variable gain means 67. Specifically, the gain value of the first variable gain means 67 is increased by 1dB.

However, when as the gain variation of the second variable gain means 73, a gain variation exceeding β dB is necessary, for example, the gain value of the first variable gain means 67 is attenuated by 1dB. In this case, when the variation of the power level of the control signal emitted from the demodulator 75 for controlling the gain of the second variable gain means 73 corresponds to the variation of the gain value of the second variable gain means 73 exceeding 2dB, then the control circuit 81 determines that the cross modulation signal is generated by the interfering waves at or after the first variable gain means 67. The gain value of the first variable gain means 67 is controlled and further increased via the gain value control means 79 for controlling the gain value of the first variable gain means 67. Specifically, the control circuit 81 controls the gain value of the first variable gain means 67 to be further attenuated by α dB, via the gain value control means 79. Thereafter, the received signal is demodulated by the demodulator 75 and converted to the base band signal, the analog signal is converted to the digital signal, then the error ratio calculation means 77 calculates the bit error ratio of the received signal. Since the demodulator 75 controls the gain value of the second variable gain means 73, the control circuit 81 knows the power level of the received signal being received by the receiver at the present time. From the thermal noise level of the receiver itself and the power level of the received signal, the control circuit 81 determines whether or not the bit error ratio calculated by the error ratio calculation means 77 is influenced by the cross modulation caused by the interfering waves, i.e. whether or not the receiving sensitivity of the receiver is deteriorated by the cross modulation.

As a result, when the control circuit 81 determines that the receiving sensitivity of the receiver is deteriorated, the control circuit 81 further attenuates the gain value of the first variable gain means 67 via the gain value control means 79 for controlling the gain value of the first variable gain means 67, and repeats the aforementioned process.

On the other hand, when the control circuit 81 determines that the receiving sensitivity of the receiver is not deteriorated, the control over the first variable gain means 67 is stopped, and signals are received from the base station for a predetermined time. After the predetermined time elapses, the gain value of the first variable gain means 67 is again attenuated by α dB, and the second variable gain means 73 is controlled. To keep constant the input power level to the demodulator 75, the variation of the gain required for the second variable gain means 73 is examined, and it is determined whether or not a plurality of interfering waves exist. When the interfering waves continue to exist, i.e. when the second variable gain means 73 requires the gain variation of β dB or more, the gain value of the first variable gain means 67 is attenuated by α dB. The aforementioned process is repeated.

Also, when it is determined that the interfering waves do not exist and the receiving sensitivity of the receiver is not deteriorated by cross modulation, i.e. when the second variable gain means 73 only requires the gain variation within β da, the control circuit 81 controls the gain value of the first variable gain means 67 to return to the initial condition via the gain value control means 79 for controlling the gain value of the first variable gain means 67. Further, after the predetermined time elapses, the control circuit 81 again controls the gain value of the first variable gain means 67, so that the gain value of the first variable gain means 67 is attenuated from the initial gain value by **α** dB. The control circuit 81 examines the presence of the cross modulation signal produced by the interfering waves. By detecting the presence of the cross modulation signal produced by the interfering waves, the aforementioned process is repeated.

As aforementioned, the cross modulation signal is an n-dimensional distortion component produced by the non-linearity of the high-frequency amplifier and the frequency mixer constituting the receiver, and has the property of increasing or decreasing by α dB in proportion when the field intensity increases or decreases by α dB. At the front end of the receiver, the first variable gain means whose gain value can be controlled is provided, and before the demodulator, the second variable gain means is provided. After the receiver receives the signal transmitted from the base station, the gain of the second variable gain means is controlled, and the input power level to the demodulator is set up to the power level which can be satisfied by the demodulator. Thereafter, the gain value of the first variable gain means provided on the front end of the receiver is attenuated by α da, then the gain of the second variable gain means is again controlled. In this case, to set the field level of the received signal transmitted to the demodulator to the power level applied in the previous process, the gain variation of β dB or more is required for the second variable gain means. For example, when the field level of the received signal is attenuated by 1dB at the front end of the receiver, while an attenuation of 2dB or more is caused before the demodulator, then it is determined that cross modulation is caused by two or more interfering waves. Further, the gain value of the first variable gain means is controlled, until the bit error ratio of the received signal reaches a sufficient value relative to the field level being received at the present time. Therefore, the presence of the cross modulation signal can be grasped without requiring a complicated process. The receiving sensitivity of the receiver can be prevented from being deteriorated by the cross modulation signal.

Also, when two or more interfering waves exist and the cross modulation signal is produced, to eliminate the deterioration of the receiving sensitivity of the receiver by means of the cross modulation signal, the front end of the receiver is provided with the first variable gain means. Further, the second variable gain means is provided after the high-frequency amplifier and the frequency mixer which tend to produce the cross modulation signal by means of two or more interfering waves. The second variable gain means is controlled using the demodulator for demodulating the received signal. The gain value of the first variable gain means is increased and the power level of the received signal is decreased, so that cross modulation is prevented from arising at the high-frequency amplifier and the frequency mixer which are provided after the first variable gain means. Even in this case, the gain of the second variable gain means can be controlled, thereby keeping the received power at a constant level. Therefore, even when the gain value of the first variable gain means is set to a remarkably large value, the received signal can be demodulated with the received power of the constant level.

It will be understood that although a particular embodiment illustrative of the invention has been described, by way of example, variations and modifications thereof, as well as other embodiments may be made within the scope of the protection sought by the appended claims.

## Claims

1. A radio receiver for use in communicating with a base station, the receiver including means (11) for receiving a signal transmitted from the base station, a first filter (17) having a bandwidth which allows a desired signal wave from a band of radio frequency signals to pass, means (83) for cbnverting a received signal in a radio frequency band to a signal in an intermediate frequency band, means (83) for extracting the converted signal in the intermediate frequency band, and control means (81) for demodulating the signal received by the receiver while controlling the gain of the received signal, wherein the control means (81) includes means (75) for demodulating the signal in the intermediate frequency band obtained from the extraction means (83), and a first variable gain means (67) provided before the frequency conversion means and having a gain which can be controlled, and wherein the extraction means (83) includes a second variable gain means (73) whose gain is controlled by the demodulating means (75).

2. A receiver as claimed in claim 1, wherein the frequency conversion means (83) includes a local signal oscillator (23) for use in converting the signal in the radio frequency band to the signal in the intermediate frequency band, and a second filter (71) arranged between the first variable gain means (67) and the demodulating means (75) for passing the received signal in the intermediate frequency band which has been converted in the frequency conversion means and which has a bandwidth which extends over at least one channel.

3. A receiver as claimed in claim 2, wherein the control means (81) includes an error ratio calculation means (77) for calculating an error ratio of the received signal from the demodulation result of the demodulating means (75) and a gain value control means (79) for controlling the gain of the first variable gain means (67), the value of the power of the signal being received being determined from a control value transmitted from the demodulating means (75) for controlling the gain of the second variable gain means (73) and a control value transmitted from the gain value control means (79) for controlling the gain of the first variable gain means (67).

4. A receiver as claimed in claim 3, wherein the receiver sets the gain of the first variable gain means (67) to a maximum gain value, and after receiving the signal from the base station, by using the demodulating means (75), controls the gain of the second variable gain means (73), so that an input power value of the demodulating means (75) is kept constant.

5. A receiver as claimed in claim 4, wherein
when the control means (81) reduces the gain of the first variable gain means (67) by α dB, to keep constant the input power value to the demodulating means (75), the demodulating means again controls the second variable gain means,
when as the variation in the gain of the second variable gain means (73), a variation within β dB is necessary, it is determined that a cross modulation signal does not influence any deterioration of the receiving sensitivity of the receiver, the first variable gain means (67) is not controlled, and the gain of the first variable gain means is reset to an initial condition,
when as the variation in the gain of the second variable gain means (73), a variation exceeding β dB is necessary, it is determined that two or more interfering waves causing cross modulation exist, the error ratio of the signal demodulated by the demodulating means is calculated by the error ratio calculation means (77), and it is determined from the value of the received power and the calculated error ratio whether or not any deterioration of the receiving sensitivity of the receiver as a result of the cross modulation occurs, and wherein
when it is determined that deterioration of the receiving sensitivity of the receiver occurs, the gain of the first variable gain means (67) is further reduced, and the control means (81) repeats the control until the error ratio of the receiver becomes less than a predetermined value.

6. A receiver as claimed in claim 5, wherein when the control means (81) determines that deterioration of the receiving sensitivity as a result of cross modulation does not occur, the control means (81) does not control the first variable gain means (67), reduces the gain of the first variable gain means by α dB after a predetermined period of time, and determines whether or not deterioration of the receiving sensitivity as a result of the cross modulation occurs.

7. A receiver as claimed in claim 6, wherein the gain variations α and β have a relationship of 2 α = β.

8. A receiver as claimed in claim 7, wherein at the time of determining whether the deterioration of the receiving sensitivity results from cross modulation, when the value of the received power is larger than a predetermined value, but the error ratio calculated by the error ratio calculation means exceeds the predetermined value, then it is determined that deterioration of the receiving sensitivity occurs.

9. A receiver as claimed in claim 3, wherein a radio frequency band amplifying means is provided after the second variable gain means (73) and has a large constant gain for reducing the value of noise in the receiver, the predetermined frequency band is the intermediate frequency band, and the demodulating means (75) is a super heterodyne system demodulator.

10. A receiver as claimed in claim 9 which includes a third filtering means (65) having a bandwidth for passing a desired signal wave among the signals received by the receiving means from among the radio frequency band signals used in the radio communication and having an output end connected to an input end of the first variable gain means (67) the first (17) and second (71) filtering means each being a band pass filter and the third filtering means (65) being an antenna sharer.

11. A receiver for achieving radio communication which includes
a receiving means (11) for receiving a signal transmitted from a base station,
a first band pass filtering means (65) having an input end connected to the receiving means (11) and having a bandwidth for passing only a desired wave signal among received signal received by the receiving means (11) among radio frequency band signals used in the radio communication,
a first variable gain means (67) connected to an output end of the first band pass filtering means (65) and having a gain which can be controlled,
a radio frequency band amplifying means (69) having a relatively large constant gain for reducing a noise value entirely in the receiver,
a second band pass filtering means (17) connected to an output end of the radio frequency band amplifying means (69) and having a bandwidth for passing only a desired wave among the radio frequency band signals,
a frequency conversion means (21) having an input end for the radio frequency band signals connected to an output end of the second band pass filtering means (17) for converting the received signal in a radio frequency band to a signal in an intermediate frequency band,
a local signal oscillating means (23) connected to an input end for a local signal of the frequency conversion means (21) for oscillating the local signal used when the signal in the radio frequency band is converted to the signal in the intermediate frequency band, a third band pass filtering means (71) connected to an output end of the frequency conversion means (21) for passing only the received signal in the intermediate frequency band converted by the frequency conversion means (21) and having a bandwidth as much as one channel.
a second variable gain means (73), connected to the third band pass filtering means (71) having the bandwidth as much as one channel and having a gain which can be controlled,
a demodulating means (75) demodulating the received signal received by the receiver, connected to an output end of the second variable gain means (73) and controlling the gain of the second variable gain means,
an error ratio calculation means (77) connected to an output end of the demodulating means for calculating an error ratio of the received signal from a demodulation result of the demodulating means, and
a gain value control means (79) for controlling the gain of the first variable gain means (67),
the receiver being constituted in such a manner that from a control value transmitted from the demodulating means (75) for controlling the gain of the second variable gain means (73) and a control value for controlling the gain of the first variable gain means (67), a power value of the received signal being received at the present time can be obtained.

12. A receiver as claimed in claim 11, wherein the receiver first sets the gain of the first variable gain means (67) to a maximum gain, after receiving the signal from the base station, by using the demodulating means (75), controls the gain of the second variable gain means (73), and keeps constant an input power value of the demodulating means (75),
subsequently, when the gain of the first variable gain means (67) is decreased by α dB, to keep constant the input power value to the demodulating means, the demodulating means (75) again controls the second variable gain means,
when as a gain variation of the second variable gain means (73), a variation within β dB is necessary, it is determined that a cross modulation signal does not influence a deterioration of a receiving sensitivity of the receiver, the first variable gain mean (67) is not controlled, and the gain of the first variable gain means is reset to an initial condition,
when as the gain variation of the second variable gain means (73), a variation exceeding β dB is necessary, it is determined that two or more interfering waves causing cross modulation exist, the error ratio of the signal demodulated by the demodulating means (75) is calculated by the error ratio calculation means, and it is determined from a present received power value and the calculated error ratio whether or not the deterioration of the receiving sensitivity of the receiver by the cross modulation occurs,
when it is determined that the deterioration of the receiving sensitivity of the receiver occurs, the gain of the first variable gain means (67) is further decreased, and control is repeated until the error ratio of the receiver becomes less than a predetermined value,
further, when the receiver determines that the deterioration of the receiving sensitivity by the cross modulation does not occur, the first variable gain means (67) is not controlled, after a predetermined time elapses, again decreases the gain of the first variable gain means by α dB, and determines whether or not the deterioration of the receiving sensitivity by the cross modulation occurs.

13. A receiver as claimed in claim 12, wherein the gain variations α and β have a relationship of 2 α = β.

14. A receiver as claimed in claim 12, wherein at the time of determining the deterioration of the receiving sensitivity by the cross modulation, when the present receiving power value is larger than the predetermined value, but the error ratio exceeds the predetermined value, then it is determined that the deterioration of the receiving sensitivity occurs.

## Patentansprüche

1. Funkempfänger für die Verwendung bei der Kommunikation mit einer Basisstation, wobei der Empfänger aufweist: eine Einrichtung (11) zum Empfangen eines von der Basisstation gesendeten Signals, ein erstes Filter (17) mit einer Bandbreite, die ermöglicht, daß eine gewünschte Signalwelle aus einem Band von Funkfrequenzsignalen durchgeht, eine Einrichtung (83) zum Umsetzen eines empfangenen Signals in einem Funkfrequenzband in ein Signal in einem Zwischenfrequenzband, eine Einrichtung (83) zum Extrahieren des umgesetzten Signals in dem Zwischenfrequenzband, und eine Regelungseinrichtung (81) zum Demodulieren des von dem Empfänger empfangenen Signals, während die Verstärkung des empfangenen Signals geregelt wird, wobei die Regelungseinrichtung (81) aufweist: eine Einrichtung (75) zum Demodulieren des Signals in dem Zwischenfrequenzband, welches von der Extraktionseinrichtung (83) erhalten wird, und eine erste variable Verstärkungseinrichtung (67), die vor der Frequenzumsetzungseinrichtung vorgesehen ist und eine regelbare Verstärkung hat, und wobei die Extraktionseinrichtung (83) eine zweite variable Verstärkungseinrichtung (73) aufweist, deren Verstärkung durch die Demodulationseinrichtung (75) geregelt wird.

2. Empfänger nach Anspruch 1, wobei die Frequenzumsetzungseinrichtung (83) aufweist: einen lokalen Signaloszillator (23) für die Verwendung beim Umsetzen des Signals in dem Funkfrequenzband in das Signal in dem Zwischenfrequenzband und ein zwischen der ersten variablen Verstärkungseinrichtung (67) und der Demodulationseinrichtung (75) angeordnetes zweites Filter (71) zum Durchlassen des empfangenen Signals in dem Zwischenfrequenzband, welches in der Frequenzumsetzungseinrichtung umgesetzt wurde und welches eine Bandbreite hat, die sich über mindestens einen Kanal erstreckt.

3. Empfänger nach Anspruch 2, wobei die Regelungseinrichtung (81) aufweist: eine Fehlerquotenberechnungseinrichtung (77) zum Berechnen einer Fehlerquote des empfangenen Signals aus dem Demodulationsergebnis der Demodulationseinrichtung (75) und eine Verstärkungswertregelungseinrichtung (79) zum Regeln der Verstärkung der ersten variablen Verstärkungseinrichtung (67), wobei der Leistungswert des empfangenen Signals bestimmt wird aus einem Regelungswert, der von der Demodulationseinrichtung (75) gesendet wird, um die Verstärkung der zweiten variablen Verstärkungseinrichtung (73) zu regeln, und aus einem Regelungswert, der von der Verstärkungswertregelungseinrichtung (79) gesendet wird, um die Verstärkung der ersten variablen Verstärkungseinrichtung (67) zu steuern.

4. Empfänger nach Anspruch 3, wobei der Empfänger die Verstärkung der ersten variablen Verstärkungseinrichtung (67) auf einen maximalen Verstärkungswert einstellt und nach dem Empfang des Signals von der Basisstation die Verstärkung der zweiten variablen Verstärkungseinrichtung (73) unter Verwendung der Demodulationseinrichtung (75) regelt, so daß ein Eingangsleistungswert der Demodulationseinrichtung (75) konstant gehalten wird.

5. Empfänger nach Anspruch 4, wobei:
wenn die Regelungseinrichtung (81) die Verstärkung der ersten variablen Verstärkungseinrichtung (67) um α dB verringert, um den Eingangsleistungswert für die Demodulationseinrichtung (75) konstant zu halten, die Demodulationseinrichtung wiederum die zweite variable Verstärkungseinrichtung regelt,
wenn als die Änderung in der Verstärkung der zweiten variablen Verstärkungseinrichtung (73) eine Änderung innerhalb β dB notwendig ist, bestimmt wird, daß ein Kreuzmodulationssignal keine Verschlechterung der Empfangsempfindlichkeit des Empfängers bewirkt, die erste regelbare Verstärkungseinrichtung (67) nicht geregelt wird und die Verstärkung der ersten variable Verstärkungseinrichtung auf einen Anfangszustand zurückgesetzt wird,
wenn als die Änderung in der Verstärkung der zweiten variablen Verstärkungseinrichtung (73) eine Änderung größer als β dB notwendig ist, bestimmt wird, daß zwei oder mehr interferierende Wellen vorhanden sind, welche eine Kreuzmodulation verursachen, wobei die Fehlerquote des durch die Demodulationseinrichtung demodulierten Signals durch die Fehlerquotenberechnungseinrichtung (77) berechnet wird und aus dem Wert der empfangenen Leistung und der berechneten Fehlerquote bestimmt wird, ob als Folge der Kreuzmodulation eine Verschlechterung der Empfangsempfindlichkeit des Empfängers auftritt oder nicht, und wobei
wenn bestimmt wird, daß eine Verschlechterung der Empfangsqualität des Empfängers auftritt, die Verstärkung der ersten variablen Verstärkungseinrichtung (67) weiter verringert wird und die Regelungseinrichtung (81) die Regelung wiederholt, bis die Fehlerquote des Empfängers niedriger als ein vorbestimmter Wert wird.

6. Empfänger nach Anspruch 5, wobei, wenn die Regelungseinrichtung (81) bestimmt, daß keine Verschlechterung der Empfangsempfindlichkeit als Folge der Kreuzmodulation auftritt, die Regelungseinrichtung (81) die erste variable Verstärkungseinrichtung (67) nicht regelt, die Verstärkung der ersten variablen Verstärkungseinrichtung nach einer vorbestimmten Zeitdauer um α dB verringert und bestimmt, ob als Folge der Kreuzmodulation eine Verschlechterung der Empfangsempfindlichkeit auftritt oder nicht.

7. Empfänger nach Anspruch 6, wobei die Verstärkungsänderungen α und β eine Beziehung von 2α = β haben.

8. Empfänger nach Anspruch 7, wobei zu dem Zeitpunkt, zu dem bestimmt wird, ob sich aus der Kreuzmodulation die Verschlechterung der Empfangsempfindlichkeit ergibt, bestimmt wird, daß die Verschlechterung der Empfangempfindlichkeit auftritt, wenn der Wert der empfangenen Leistung größer als ein vorbestimmter Wert ist, aber die durch die Fehlerquotenberechnungseinrichtung berechnete Fehlerquote den vorbestimmten Wert überschreitet.

9. Empfänger nach Anspruch 3, wobei eine Funkfrequenzbandverstärkungseinrichtung nach der zweiten variablen Verstärkungseinrichtung (73) vorgesehen ist, die eine große konstante Verstärkung hat, um den Wert des Rauschens in dem Empfänger zu verringern, wobei das vorbestimmte Frequenzband das Zwischenfrequenzband ist und die Demodulationseinrichtung (75) ein Überlagerungssystemdemodulator ist.

10. Empfänger nach Anspruch 9, der eine dritte Filtereinrichtung (65) mit einer Bandbreite zum Durchlassen einer gewünschten Signalwelle aus den von der Empfangseinrichtung empfangenen Signalen aus den in der Funkkommunikation verwendeten Funkfrequenzbandsignalen aufweist, die einen Ausgang hat, der mit einem Eingang der ersten variablen Verstärkungseinrichtung (67) verbunden ist, wobei die erste (17) und die zweite (71) Filtereinrichtung jeweils ein Bandpaßfilter sind und die dritte Filtereinrichtung (65) ein Antennenteiler (65) ist.

11. Empfänger für das Erzielen einer Funkkommunikation, der aufweist:
eine Empfangseinrichtung (11) zum Empfangen eines von einer Basisstation gesendeten Signals,
eine erste Bandpaßfiltereinrichtung (65) mit einem Eingang, der mit der Empfangseinrichtung (11) verbunden ist, welche eine Bandbreite hat, um nur ein gewünschtes Wellensignal aus empfangenen Signalen durchzulassen, die von der Empfangseinrichtung (11) aus den in der Funkkommunikation verwendeten Funkfrequenzbandsignalen empfangen werden,
eine mit einem Ausgang der ersten Bandpaßfiltereinrichtung (65) verbundene erste variable Verstärkungseinrichtung (67) mit einer Verstärkung, die geregelt werden kann,
eine Funkfrequenzbandverstärkungseinrichtung (69) mit einer relativ großen konstanten Verstärkung, um einen Rauschwert insgesamt in dem Empfänger zu verringern,
eine mit einem Ausgang der Funkfrequenzbandverstärkungseinrichtung (69) verbundene zweite Bandpaßfiltereinrichtung (17) mit einer Bandbreite, um nur eine gewünschte Welle unter den Funkfrequenzbandsignalen durchzulassen,
eine Frequenzumsetzungseinrichtung (21) mit einem Eingang für die Funkfrequenzbandsignale, der mit einem Ausgang der zweiten Bandpaßfiltereinrichtung (17) verbunden ist, um das empfangene Signal in einem Funkfrequenzband in ein Signal in einem Zwischenfrequenzband umzusetzen,
eine lokale Signaloszillationseinrichtung (23), die mit einem Eingang für ein lokales Signal der Frequenzumsetzungseinrichtung (21) verbunden ist, um das lokale Signal zu oszillieren, welche verwendet wird, wenn das Signal in dem Funkfrequenzband in das Signal in dem Zwischenfrequenzband umgesetzt wird,
eine mit einem Ausgang der Frequenzumsetzungeinrichtung (21) verbundene dritte Bandpaßfiltereinrichtung (71), um nur das empfangene Signal in dem Zwischenfrequenzband durchzulassen, das von der Frequenzumsetzungseinrichtung (21) umgesetzt wurde und eine Bandbreite von so viel wie ein Kanal hat,
eine mit der dritten Bandpaßfiltereinrichtung (71) verbundene zweite regelbare Verstärkungseinrichtung (73) mit einer Bandbreite von so viel wie einem Kanal und mit einer Verstärkung, die geregelt werden kann,
eine Demodulationseinrichtung (75), die das von dem Empfänger empfangene Signal demoduliert, welche mit einem Ausgang der zweiten variablen Verstärkungseinrichtung (73) verbunden ist und die Verstärkung der zweiten variable Verstärkungseinrichtung regelt,
eine mit einem Ausgang der Demodulationseinrichtung verbundene Fehlerquotenberechnungseinrichtung (77), um eine Fehlerquote des empfangenen Signals aus einem Demodulationsergebnis der Demodulationseinrichtung zu berechnen, und
eine Verstärkungswertregelungseinrichtung (79) zum Regeln der Verstärkung der ersten variablen Verstärkungseinrichtung (67),
wobei der Empfänger derart aufgebaut ist, daß aus einem von der Demodulationseinrichtung (75) gesendeten Regelungswert zum Regeln der Verstärkung der zweiten variablen Verstärkungseinrichtung (73) und einem Regelungswert zum Regeln der Verstärkung der ersten variablen Verstärkungseinrichtung (67) ein Leistungswert des empfangenen Signals, das gegenwärtig empfangen wird, erhalten werden kann.

12. Empfänger nach Anspruch 11, wobei der Empfänger, nachdem er das Signal von der Basisstation empfangen hat, zuerst die Verstärkung der ersten variablen Verstärkungseinrichtung (67) unter Verwendung der Demodulationseinrichtung (75) auf eine maximale Verstärkung einstellt, die Verstärkung der zweiten variablen Verstärkungseinrichtung (73) regelt und einen Eingangsleistungswert der Demodulationseinrichtung (75) konstant hält,
danach, wenn die Verstärkung der ersten variablen Verstärkungseinrichtung (67) um α dB verringert wird, regelt die Demodulationseinrichtung (75) wieder die zweite variable Verstärkungseinrichtung, um den Eingangsleistungswert an die Demodulationseinrichtung konstant zu halten,
wenn als eine Verstärkungsänderung der zweiten variablen Verstärkungseinrichtung (73) eine Änderung innerhalb von β dB notwendig ist, wird bestimmt, daß ein Kreuzmodulationssignal keine Verschlechterung der Empfangsempfindlichkeit des Empfängers bewirkt, die erste variable Verstärkungseinrichtung (67) wird nicht geregelt und die Verstärkung der ersten variablen Verstärkungseinrichtung wird auf einen Anfangszustand zurückgesetzt,
wenn als die Verstärkungsänderung der zweiten variablen Verstärkungseinrichtung (73) eine Änderung größer als β dB notwendig ist, wird bestimmt, daß zwei oder mehr interferierende Wellen vorhanden sind, welche eine Kreuzmodulation verursachen, wobei die Fehlerquote des durch die Demodulationseinrichtung (75) demodulierten Signals durch die Fehlerquotenberechnungseinrichtung berechnet wird und aus dem Wert einer gerade empfangenen Leistung und der berechneten Fehlerquote wird bestimmt, ob als Folge der Kreuzmodulation eine Verschlechterung der Empfangsempfindlichkeit des Empfängers auftritt oder nicht,
wenn bestimmt wird, daß die Verschlechterung der Empfangsqualität des Empfängers auftritt, wird die Verstärkung der ersten variablen Verstärkungseinrichtung (67) weiter verringert und die Regelung wird wiederholt, bis die Fehlerquote des Empfängers niedriger als ein vorbestimmter Wert wird,
wenn der Empfänger ferner bestimmt, daß die Verschlechterung der Empfangsempfindlichkeit durch die Kreuzmodulation nicht auftritt, wird die erste variable Verstärkungseinrichtung (67) nicht geregelt, nachdem eine vorbestimmte Zeit verstrichen ist, wird die Verstärkung der ersten variablen Verstärkungseinrichtung um α dB wieder verringert und bestimmt, ob die Verschlechterung der Empfangsempfindlichkeit durch die Kreuzmodulation auftritt oder nicht.

13. Empfänger nach Anspruch 12, wobei die Verstärkungsänderungen α und β eine Beziehung von 2α = β haben.

14. Empfänger nach Anspruch 12, wobei zu dem Zeitpunkt, zu dem die Verschlechterung der Empfangsempfindlichkeit durch die Kreuzmodulation bestimmt wird, bestimmt wird, daß die Verschlechterung der Empfangsempfindlichkeit auftritt, wenn die aktuelle Empfangsleistung größer als der vorbestimmte Wert ist, aber die Fehlerquote den vorbestimmten Wert übersteigt.

## Revendications

1. Récepteur radio pour utilisation en communication avec une station de base, le récepteur comprenant des moyens (11) pour recevoir un signal émis par la station de base, un premier filtre (17) ayant une largeur de bande qui permet le passage d'une onde souhaitée d'un signal d'une bande de fréquences radioélectriques de signaux, des moyens (83) pour convertir un signal reçu dans une bande de fréquences radioélectriques en un signal dans une bande de fréquence intermédiaire, des moyens (83) pour extraire le signal converti dans la bande de fréquence intermédiaire, et des moyens de contrôle (81) pour démoduler le signal reçu par le récepteur tout en contrôlant le gain du signal reçu, dans lequel les moyens de contrôle (81) comprennent des moyens (75) pour démoduler le signal en bande de fréquences intermédiaires obtenue par les moyens d'extraction (83), et des premiers moyens de gain variable (67) situés avant les moyens de conversion de fréquences et ayant un gain qui peut être contrôlé, et dans lequel les moyens d'extraction (83) comprennent de seconds moyens de gain variable (73) dont le gain est contrôlé par les moyens de démodulation (75).

2. Récepteur selon la revendication 1, dans lequel les moyens de conversion de fréquences (83) comprennent un oscillateur local (23) de signal pour utilisation dans la conversion de signal de la bande de fréquences radioélectriques en signal en bande de fréquence intermédiaire, et un second filtre (71) disposé entre les premiers moyens de gain variable (67) et les moyens de démodulation (75) pour laisser passer le signal reçu qui a été converti en bande de fréquences intermédiaires dans les moyens de conversion de fréquences et qui a une largeur de bande qui s'étend sur au moins un canal.

3. Récepteur selon la revendication 2, dans lequel les moyens de contrôle (81) comprennent des moyens (77) de calcul du taux d'erreur pour calculer un taux d'erreur du signal reçu à partir du résultat de la démodulation des moyens de démodulation (75) et des moyens (79) de contrôle de la valeur du gain pour contrôler le gain des premiers moyens de gain variable (67), la valeur de la puissance du signal reçu étant déterminée à partir d'une valeur de contrôle transmise par les moyens de démodulation (75) pour contrôler le gain des seconds moyens de gain variable (73) et d'une valeur de contrôle transmise par les moyens (79) de contrôle de la valeur du gain pour contrôler le gain des premiers moyens de gain variable (67).

4. Récepteur selon la revendication 3, dans lequel le récepteur fixe le gain des premiers moyens de gain variable (67) à une valeur de gain maximale, et après réception du signal de la station de base, en utilisant les moyens de démodulation (75), contrôle le gain des seconds moyens de gain variable (73), de sorte qu'une valeur de puissance en entrée des moyens de démodulation (75) soit maintenue constante.

5. Récepteur selon la revendication 4, dans lequel
quand les moyens de contrôle (81) réduisent le gain des premiers moyens de gain variable (67) de α dB, pour garder constante la valeur de puissance d'entrée des moyens de démodulation (75), les moyens de démodulation contrôlent à nouveau les seconds moyens de gain variable,
quand comme variation du gain des seconds moyens de gain variable (73), une variation dans l'intervalle de β dB est nécessaire, il est déterminé qu'un signal de transmodulation n'influence pas une quelconque détérioration de la sensibilité de réception du récepteur, les premiers moyens de gain variable (67) ne sont pas contrôlés, et le gain des premiers moyens de gain variable est remis à une condition initiale,
quand comme variation du gain des seconds moyens de gain variable (73), une variation excédant β dB est nécessaire, il est déterminé que deux ondes parasites ou plus entraînant une transmodulation existent, le taux d'erreur du signal démodulé par les moyens de démodulation est calculé par les moyens (77) de calcul du taux d'erreur, et il est déterminé à partir de la valeur de la puissance reçue et du taux d'erreur calculé s'il y a ou non détérioration de la sensibilité de réception du récepteur liée à la présence d'une transmodulation, et dans lequel
quand il est déterminé qu'une détérioration de la sensibilité de réception du récepteur se produit, le gain des premiers moyens de gain variable (67) est réduit à nouveau, et les moyens de contrôle (81) répète le contrôle jusqu'à ce que le taux d'erreur du récepteur soit inférieur à une valeur prédéterminée.

6. Récepteur selon la revendication 5, dans lequel lorsque les moyens de contrôle (81) déterminent que la détérioration de la sensibilité de réception liée à la transmodulation ne se produit pas, les moyens de contrôle (81) ne contrôlent pas les premiers moyens de gain variable (67), réduisent le gain des premiers moyens de gain variable de α dB après une période de temps prédéterminée, et déterminent s'il y a ou non détérioration de la sensibilité de réception liée à la transmodulation.

7. Récepteur selon la revendication 6, dans lequel les variations de gain α et β répondent à la relation 2 α = β.

8. Récepteur selon la revendication 7, dans lequel au moment de déterminer si la détérioration de la sensibilité de réception résulte d'une transmodulation, quand la valeur de la puissance reçue est supérieure à une valeur prédéterminée, mais que le taux d'erreur calculé par les moyens de calcul du taux d'erreur dépasse la valeur prédéterminée, alors il est déterminé qu'une détérioration de la sensibilité de réception est présente.

9. Récepteur selon la revendication 3, dans lequel des moyens d'amplification de bande de fréquences radioélectriques sont situés après les seconds moyens de gain variable (73) et a un gain constant important pour réduire la valeur du bruit dans le récepteur, la bande de fréquences prédéterminée est la bande de fréquences intermédiaires, et les moyens de démodulation (75) sont un démodulateur à système superhétérodyne.

10. Récepteur selon la revendication 9, qui comprend des troisièmes moyens de filtrage (65) ayant une largeur de bande pour laisser passer l'onde souhaitée de signal parmi les signaux reçus par les moyens de réception parmi les signaux à bande de fréquences radioélectriques utilisés dans la communication radioélectrique et ayant une borne de sortie reliée à une borne d'entrée des premiers moyens de gain variable (67), les premiers (17) et les deuxièmes (71) moyens de filtrage étant chacun un filtre passe-bande et les troisièmes moyens de filtrage (65) étant un séparateur d'antenne.

11. Récepteur pour réaliser une communication, radioélectrique qui comprend
des moyens de réception (11) pour recevoir un signal émis par une station de base,
des premiers moyens (65) de filtrage passe-bande ayant une borne d'entrée connectée aux moyens de réception (11) et ayant une largeur de bande pour laisser passer uniquement une onde souhaitée de signal parmi les signaux reçus par les moyens de réception (11) parmi les signaux à bande de fréquences radioélectriques utilisés dans la communication radioélectrique,
des premiers moyens de gain variable (67) connectés à une borne d'entrée des premiers moyens de filtrage passe-bande (65) et ayant un gain qui peut être contrôlé,
des moyens d'amplification de bande de fréquences radioélectriques (69) ayant un gain constant relativement important pour réduire entièrement une valeur de bruit dans le récepteur,
des deuxièmes moyens de filtrage passe-bande (17) connectés à une borne de sortie des moyens d'amplification de bande de fréquences radioélectriques (69) et ayant une largeur de bande pour laisser passer uniquement une onde souhaitée parmi les signaux de la bande de fréquences radioélectriques,
des moyens de conversion de fréquences (21) ayant une borne d'entrée pour les signaux de la bande de fréquences radioélectriques connectée à une borne de sortie des deuxièmes moyens (17) de filtrage passe-bande pour convertir le signal reçu dans une bande de fréquences radioélectriques en un signal en bande de fréquences intermédiaires,
des moyens d'oscillation (23) de signaux locaux connectés à une borne d'entrée pour un signal local des moyens de conversion de fréquences (21) pour faire osciller le signal local utilisé lorsque le signal dans la bande de fréquences radioélectriques est converti en signal en bande de fréquences intermédiaires,
des troisièmes moyens (71) de filtrage passe-bande connectés à une borne de sortie des moyens de conversion de fréquences (21) pour laisser passer uniquement le signal reçu converti dans la bande de fréquence intermédiaire par les moyens de conversion de fréquences (21) et ayant une largeur de bande aussi importante qu'un canal,
des seconds moyens de gain variable (73) connectés aux troisièmes moyens de filtrage passe-bande (71) ayant la largeur de bande aussi importante qu'un canal et ayant un gain qui peut être contrôlé,
des moyens de démodulation (75) démodulant le signal reçu par le récepteur, connectés à une borne de sortie des seconds moyens de gain variable (73) et contrôlant le gain des seconds moyens de gain variable,
des moyens de calcul de taux d'erreur (77) connectés à une borne d'entrée des moyens de démodulation pour calculer un taux d'erreur du signal reçu à partir d'un résultat de démodulation des moyens de démodulation, et
des moyens de contrôle de la valeur de gain (79) pour contrôler le gain des premiers moyens de gain variable (67),
le récepteur étant constitué de manière telle que à partir d'une valeur de contrôle transmise par les moyens de démodulation (75) pour contrôler le gain des seconds moyens de gain variable (73) et d'une valeur de contrôle pour contrôler le gain des premiers moyens de gain variable (67), une valeur de puissance reçue à l'instant présent du signal reçu peut être obtenue.

12. Récepteur selon la revendication 11, dans lequel le récepteur fixe d'abord le gain des premiers moyens de gain variable (67) à un gain maximal, après réception du signal de la station de base, en utilisant les moyens de démodulation (75), contrôle le gain des seconds moyens de gain variable (73), et maintient constante une valeur de puissance d'entrée des moyens de démodulation (75),
ensuite, lorsque le gain des premiers moyens de gain variable (67) est réduit de α dB, pour maintenir constante la valeur de puissance en entrée des moyens de démodulation, les moyens de démodulation (75) contrôlent à nouveau les seconds moyens de gain variable,
quand comme variation du gain des seconds moyens de gain variable (73), une variation de β dB est nécessaire, il est déterminé qu'un signal de transmodulation n'influence pas une détérioration d'une sensibilité de réception du récepteur, les premiers moyens de gain variable (67) ne sont pas contrôlés, et le gain des premiers moyens de gain variable est fixé à nouveau à une condition initiale,
quand comme variation du gain des seconds moyens de gain variable (73), une variation supérieure à β dB est nécessaire, il est déterminé que deux ondes parasites ou plus provoquant une transmodulation existent, le taux d'erreur du signal démodulé par les moyens de démodulation (75) est calculé par les moyens de calcul de taux d'erreur, et il est déterminé à partir d'une présente valeur de puissance reçue et du taux d'erreur calculé s'il y a ou non détérioration de la sensibilité de réception du récepteur liée à la transmodulation,
lorsqu'il est déterminé que la détérioration de la sensibilité de réception du récepteur est présente, le gain des premiers moyens de gain variable (67) est réduit à nouveau, et le contrôle est répété jusqu'à ce que le taux d'erreur du récepteur soit inférieur à une valeur prédéterminée,
en outre, lorsque le récepteur détermine que la détérioration de la sensibilité de réception liée à la transmodulation n'est pas présente, les premiers moyens de gain variable (67) ne sont pas contrôlés, après un lapse de temps prédéterminé, réduit à nouveau le gain des premiers moyens de gain variable de α dB, et détermine s'il y a ou non détérioration de la sensibilité de réception liée à transmodulation.

13. Récepteur selon la revendication 12, dans lequel les variations de gain α et β répondent à la relation 2 α = β.

14. Récepteur selon la revendication 12, dans lequel au moment de la détermination de la détérioration de la sensibilité de réception liée à la transmodulation, lorsque la présente valeur de puissance reçue est supérieure à la valeur prédéterminée, mais que le taux d'erreur est supérieur à la valeur prédéterminée, alors il est déterminé qu'il y a détérioration de la sensibilité de réception.
